# EUROPEAN PATENT SPECIFICATION

(11) **EP 4 174 944 B1**
(45) Date of publication and mention of the grant of the patent: **24.07.2024**
(21) Application number: 22205066.8
(22) Date of filing: 02.11.2022
(51) Int. Cl.: H01L 33/38, H01L 33/44, H01L 25/075, H01L 33/62

(54) **DISPLAY DEVICE INCLUDING A SEMICONDUCTOR LIGHT EMITTING DEVICE**
ANZEIGEVORRICHTUNG MIT EINER LICHTEMITTIERENDEN HALBLEITERVORRICHTUNG
DISPOSITIF D'AFFICHAGE COMPRENANT UN DISPOSITIF ÉLECTROLUMINESCENT À SEMI-CONDUCTEUR

(30) Priority: 02.11.2021 KR 20210148441
(43) Date of publication of application: 03.05.2023
(73) Proprietor: LG Electronics Inc., Seoul 07336 (KR)
(72) Inventor: MOON, Seongmin, Seoul 06772 (KR); BYUN, Yangwoo, Seoul 06772 (KR); JEON, Kiseong, Seoul 06772 (KR); LEE, Jinhyung, Seoul 06772 (KR)
(74) Representative: Vossius & Partner Patentanwälte Rechtsanwälte mbB

(56) References cited:
- WO-A1-2021/033802
- WO-A1-2021/040066
- WO-A1-2021/070977
- WO-A1-2023/003049

## Description

### 1. Field of the Disclosure

The present invention relates to a display device including a semiconductor light emitting device.

### 2. Discussion of the Related Art

Large-area displays include a liquid crystal display (LCD), an OLED displays, a micro-LED display, among others.

A micro-LED display is a display using a micro-LED, which is a semiconductor light emitting device having a diameter or cross-sectional area of 100µm or less, as a display device.

Therefore Micro-LED display that uses micro-LED has excellent performance in many characteristics such as contrast ratio, response speed, color gamut, viewing angle, brightness, resolution, lifespan, luminous efficiency and luminance.

In particular, micro-LED displays have the advantage of being able to separate and combine screens in a modular way, so that size or resolution can be freely adjusted and flexible displays can be implemented.

However, since large-sized micro-LED displays require millions of micro-LEDs, there is a technical problem in that it is difficult to quickly and accurately transfer micro-LEDs to a display panel.

Transfer technologies that have been recently developed include a pick and place process, a laser lift-off method, or a self-assembly method.

Among these, the self-assembly method is a method in which the semiconductor light emitting device finds an assembly position in a fluid and is advantageous for implementation of a large-screen display device.

Recently, although a micro-LED structure suitable for self-assembly has been proposed in U.S. Patent No. 9,825,202, for example, research on a technology for manufacturing a display through self-assembly of micro-LED is still insufficient.

WO 2021033802 A1 discloses a display device including a semiconductor light emitting device.

In particular, in the case of rapidly transferring millions of semiconductor light emitting devices to a large display in the prior art, although the transfer speed can be improved, there is a technical problem in that the transfer error rate can be increased, so that the transfer yield is lowered.

In the related art, a self-assembly method using dielectrophoresis (DEP) has been attempted, but the self-assembly rate is low due to the non-uniformity of the DEP force.

Meanwhile, according to the undisclosed internal technology, self-assembly requires a DEP force, but due to the difficulty of uniform control of the DEP force, there is a problem in that the semiconductor light emitting device is tilted to a different location in the assembly hole during assembly using self-assembly.

In addition, in the subsequent electrical contact process due to the tilting phenomenon of the semiconductor light emitting device, there is a problem in that the electrical contact characteristics are reduced and the lighting rate is lowered.

Therefore, according to the unpublished internal technology, even though DEP force is required for self-assembly, but when using the DEP force, the semiconductor light emitting device faces a technical contradiction in which electrical contact characteristics are reduced due to the leaning phenomenon.

### SUMMARY OF THE DISCLOSURE

One of the technical problems of the present invention is to solve the problem of low self-assembly rate due to non-uniformity of DEP force in the self-assembly method using dielectrophoresis (DEP).

Further, one of the technical problems of the present invention is to solve the problem that the lighting rate is lowered due to the deterioration of electrical contact characteristics between the electrodes of the self-assembled light emitting device and a predetermined panel electrode.

The technical problems of the present invention are not limited to those described in this item, and include those that can be understood throughout the specification.

The present invention provides a display device including a semiconductor light emitting device according to claim 1.

The side electrode can be electrically connected to the first conductivity type semiconductor layer of the semiconductor light emitting device.

The embodiment can further include a first panel electrode electrically connected to the side electrode.

The semiconductor light emitting device can include an undoped semiconductor layer disposed under the first conductivity type semiconductor layer.

The side electrode can include a first side electrode in contact with the semiconductor light emitting device and a second side electrode extending from the first side electrode and electrically connected to the first panel electrode.

The embodiment can further include a first-second panel electrode connected to the side electrode and the first assembly electrode or the second assembly electrode.

The assembly barrier wall can include a contact hole exposing at least one of the first assembly electrode or the second assembly electrode.

The assembly barrier wall can include a contact hole in which the first insulating layer and a part of the assembly barrier wall is removed to expose the second assembly electrode.

The first-second panel electrode can be disposed in the contact hole, and can be connected to the second assembly electrode.

According to the semiconductor light emitting device and the display device including the same, in the self-assembly method using dielectrophoresis (DEP), there is a technical effect that can solve the problem of low self-assembly rate due to non-uniformity of DEP force.

In addition, according to the present invention, there is a technical effect that the lighting rate can be significantly increased by increasing the electrical contact area between the semiconductor light emitting device and the panel electrode, thereby improving the electrical contact characteristics.

The technical effects of the embodiments are not limited to those described in this item, and include those identified from the description of the invention.

### BRIEF DESCRIPTION OF THE DRAWINGS

The present invention will become more fully understood from the detailed description given hereinbelow and the accompanying drawings which are given by way of illustration only, and thus are not limitative of the present invention.
FIG. 1 is an example view of a living room of a house in which a display device according to an embodiment is disposed.
FIG. 2 is a block diagram schematically showing a display device according to an embodiment.
FIG. 3 is a circuit diagram illustrating an example of the pixel of FIG. 2.
FIG. 4 is an enlarged view of a first panel area in the display device of FIG. 1.
FIG. 5 is a cross-sectional view taken along line B1-B2 of area A2 of FIG. 4.
FIG. 6 is an example view in which the light emitting device according to the embodiment is assembled on a substrate by a self-assembly method.
FIG. 7 is a partially enlarged view of area A3 of FIG. 6.
FIGS. 8A to 8B are views illustrating self-assembly in the display device 300 according to the internal technology.
FIG. 8C is a self-assembled photograph in the display device according to the internal technology.
FIG. 8D is a view showing a tilt phenomenon that occurs during self-assembly to the internal technology.
FIG. 8E is a FIB (focused ion beam) photograph of a light emitting device (chip) and a bonding metal in a display panel according to an internal technology.
FIG. 8F is lighting data in the display panel in the internal technology.
FIG. 9 is a plan view of a display device 301 including a semiconductor light emitting device according to the first embodiment.
FIG. 10A is a cross-sectional view taken along line A1-A2 of the display device 301 including the semiconductor light emitting device according to the first embodiment shown in FIG. 9.
FIG. 10B is a cross-sectional view taken along line A3-A4 of the display device 301 including the semiconductor light emitting device according to the first embodiment shown in FIG. 9.
FIG. 11 is a cross-sectional photograph of a display device 301 including a semiconductor light emitting device according to an embodiment.
FIG. 12A is a photograph showing the lighting uniformity of a display device including a semiconductor light emitting device in a comparative example.
FIGS. 12B and 12C are photographs showing the lighting uniformity of the display device 301 including the semiconductor light emitting device according to the embodiment.
FIGS. 13A to 13H are cross-sectional views illustrating a manufacturing process of the display device 301 including the semiconductor light emitting device according to the first embodiment.
FIG. 14A is a plan view of a display device 300B including a semiconductor light emitting device according to a second example embodiment.
FIG. 14B is a cross-sectional view taken along line A5-A6 of the display device 300B including the semiconductor light emitting device according to the second embodiment shown in FIG. 14A.
FIGS. 15A to 15C are cross-sectional views illustrating a manufacturing process of a display device 300B including a semiconductor light emitting device according to a second example embodiment.

### DETAILED DESCRIPTION OF THE EMBODIMENTS

Hereinafter, embodiments disclosed in the present description will be described in detail with reference to the accompanying drawings. The suffixes 'module' and 'part' for components used in the following description are given or mixed in consideration of ease of specification, and do not have a meaning or role distinct from each other by themselves. In addition, the accompanying drawings are provided for easy understanding of the embodiments disclosed in the present specification, and the technical ideas disclosed in the present specification are not limited by the accompanying drawings. Further, when an element, such as a layer, region, or substrate, is referred to as being 'on' another component, this includes that it is directly on the other element or there can be other intermediate elements in between.

The display device described in this specification can include a digital TV, a mobile phone, a smart phone, a laptop computer, a digital broadcasting terminal, a personal digital assistant (PDA), a portable multimedia player (PMP), a navigation, a Slate PC, a Tablet PC, an Ultra-Book, a desktop computer, and the like. However, the configuration according to the embodiment described in this specification can be applied to a display capable device even if it is a new product form to be developed later.

Hereinafter, a light emitting device according to an embodiment and a display device including the same will be described.

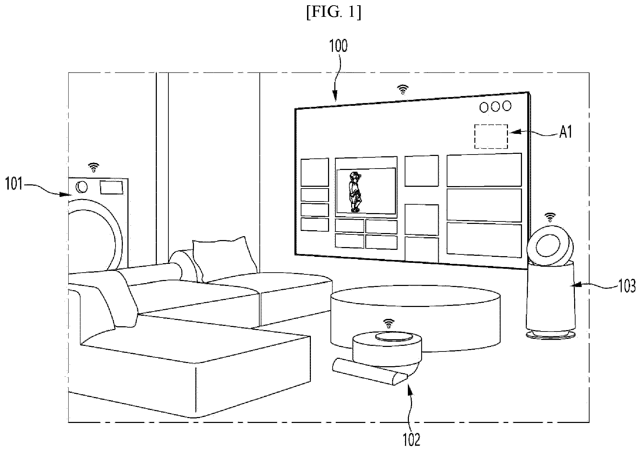

FIG. 1 shows a living room of a house in which the display device 100 according to the embodiment is disposed.

The display device 100 of the embodiment can display the status of various electronic products such as the washing machine 101, the robot cleaner 102, and the air purifier 103, and communicate with each electronic product based on IOT, and can control each electronic product based on the user's setting data.

The display device 100 according to the embodiment can include a flexible display manufactured on a thin and flexible substrate. The flexible display can be bent or rolled like paper while maintaining the characteristics of the conventional flat panel display.

In the flexible display, visual information can be implemented by independently controlling light emission of unit pixels arranged in a matrix form. A unit pixel means a minimum unit for realizing one color. The unit pixel of the flexible display can be implemented by a light emitting device. In an embodiment, the light emitting device can be a Micro-LED or a Nano-LED, but is not limited thereto.

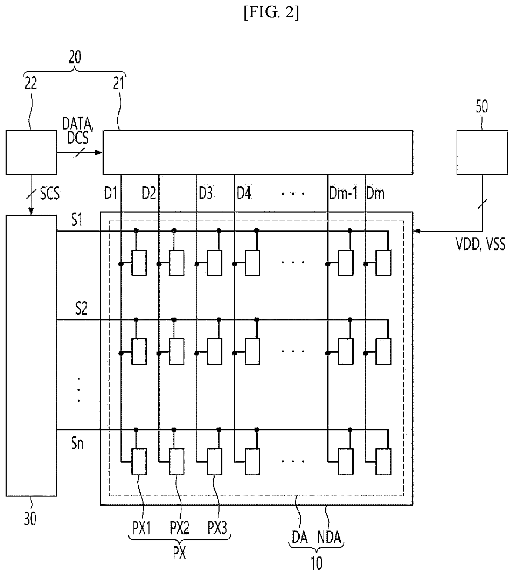

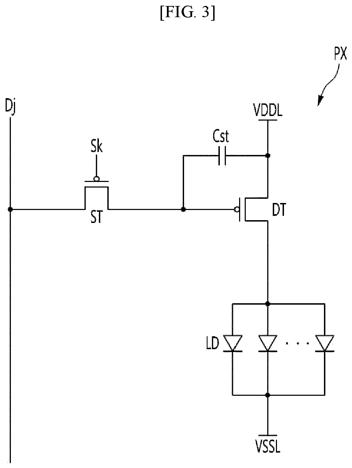

Next, FIG. 2 is a block diagram schematically showing a display device according to an embodiment, and FIG. 3 is a circuit diagram showing an example of the pixel of FIG. 2.

Referring to FIGS. 2 and 3, the display device according to the embodiment can include a display panel 10, a driving circuit 20, a scan driving unit 30, and a power supply circuit 50.

The display device 100 according to the embodiment can drive the light emitting device using an active matrix (AM) method or a passive matrix (PM, passive matrix) method.

The driving circuit 20 can include a data driving unit 21 and a timing control unit 22.

The display panel 10 can be divided into a display area DA and a non-display area NDA disposed around the display area DA. The display area DA is an area in which pixels PX are formed to display an image. The display panel 10 can include data lines (D1 to Dm, m is an integer greater than or equal to 2), scan lines crossing the data lines D1 to Dm (S1 to Sn, n is an integer greater than or equal to 2), the high-potential voltage line supplied with the high-voltage, the low-potential voltage line supplied with the low-potential voltage, and the pixels PX connected to the data lines D1 to Dm and the scan lines S1 to Sn can be included.

Each of the pixels PX can include a first sub-pixel PX1, a second sub-pixel PX2, and a third sub-pixel PX3. The first sub-pixel PX1 emits a first color light of a first wave, the second sub-pixel PX2 emits a second color light of a second wave, and the third sub-pixel PX3 emits a third color light of a wave can be emitted. The first color light can be red light, the second color light can be green light, and the third color light can be blue light, but is not limited thereto. Further, although it is illustrated that each of the pixels PX can include three sub-pixels in FIG. 2, the present invention is not limited thereto. For example, each of the pixels PX can include four or more sub-pixels.

Each of the first sub-pixel PX1, the second sub-pixel PX2, and the third sub-pixel PX3 can be connected to at least one of the data lines D1 to Dm, and at least one of the scan lines S 1 to Sn, and a high potential voltage line. As shown in FIG. 3, the first sub-pixel PX1 can include the light emitting devices LD, plurality of transistors for supplying current to the light emitting devices LD, and at least one capacitor Cst.

Each of the first sub-pixel PX1, the second sub-pixel PX2, and the third sub-pixel PX3 can include only one light emitting device LD and at least one capacitor Cst.

Each of the light emitting devices LD can be a semiconductor light emitting diode including a first electrode, a plurality of conductivity type semiconductor layers, and a second electrode. Here, the first electrode can be an anode electrode and the second electrode can be a cathode electrode, but the present invention is not limited thereto.

Referring to FIG. 3, the plurality of transistors can include a driving transistor DT for supplying current to the light emitting devices LD, and a scan transistor ST for supplying a data voltage to the gate electrode of the driving transistor DT. The driving transistor DT can include a gate electrode connected to the source electrode of the scan transistor ST, a source electrode connected to a high potential voltage line to which a high potential voltage is applied, and a drain electrode connected to first electrodes of the light emitting devices LD. The scan transistor ST can include a gate electrode connected to the scan line Sk, where k is an integer satisfying 1≤k≤n, a source electrode connected to the gate electrode of the driving transistor DT, and a drain electrode connected to data lines Dj, where j is integer satisfying 1≤j≤m.

The capacitor Cst can be formed between the gate electrode and the source electrode of the driving transistor DT. The storage capacitor Cst can charge a difference between the gate voltage and the source voltage of the driving transistor DT.

The driving transistor DT and the scan transistor ST can be formed of a thin film transistor. In addition, although the driving transistor DT and the scan transistor ST have been mainly described in FIG. 3 as being formed of a P-type MOSFET (Metal Oxide Semiconductor Field Effect Transistor), the present invention is not limited thereto. The driving transistor DT and the scan transistor ST can be formed of an N-type MOSFET. In this case, the positions of the source electrode and the drain electrode of each of the driving transistor DT and the scan transistor ST can be changed.

Further, in FIG. 3 has been illustrated each of the first sub-pixel PX1, the second sub-pixel PX2, and the third sub-pixel PX3 can include one driving transistor DT, one scan transistor ST, and 2T1C (2 Transistor - 1 capacitor) having a capacitor Cst, but the present invention is not limited thereto. Each of the first sub-pixel PX1, the second sub-pixel PX2, and the third sub-pixel PX3 can include a plurality of scan transistors ST and a plurality of capacitors Cst.

Referring back to FIG. 2, the driving circuit 20 outputs signals and voltages for driving the display panel 10. To this end, the driving circuit 20 can include a data driver 21 and a timing controller 22.

The data driver 21 receives digital video data DATA and a source control signal DCS from the timing controller 22. The data driver 21 converts the digital video data DATA into analog data voltages according to the source control signal DCS and supplies them to the data lines D1 to Dm of the display panel 10.

The timing controller 22 receives digital video data DATA and timing signals from the host system. The timing signals can include a vertical sync signal, a horizontal sync signal, a data enable signal, and a dot clock. The host system can be an application processor of a smartphone or a tablet PC, a monitor, or a system-on-chip of a TV.

The scan driver 30 receives the scan control signal SCS from the timing controller 22. The scan driver 30 generates scan signals according to the scan control signal SCS and supplies them to the scan lines S1 to Sn of the display panel 10. The scan driver 30 can include a plurality of transistors and can be formed in the non-display area NDA of the display panel 10. Further, the scan driver 30 can be formed of an integrated circuit, and in this case, can be assembled on a gate flexible film attached to the other side of the display panel 10.

The power supply circuit 50 generates a high potential voltage VDD and a low potential voltage VSS for driving the light emitting devices LD of the display panel 10 from the main power source, and the power supply circuit can supply VDD and VSS to the high-potential voltage line and the low-potential voltage line of the display panel 10. Further, the power supply circuit 50 can generate and supply driving voltages for driving the driving circuit 20 and the scan driving unit 30 from the main power.

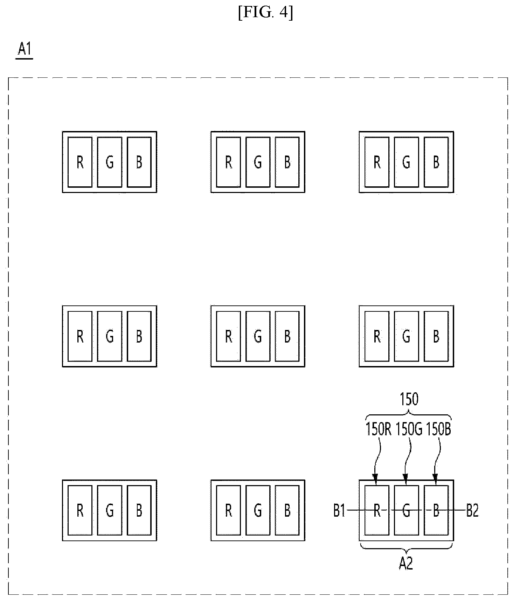

Next, FIG. 4 is an enlarged view of the first panel area A1 in the display device of FIG. 1.

Referring to FIG. 4, the display device 100 according to the embodiment can be manufactured by mechanically and electrically connecting a plurality of panel regions such as the first panel region A1 by tiling.

The first panel area A1 can include a plurality of light emitting devices arranged for each unit pixel (PX in FIG. 2).

For example, the unit pixel PX can include a first sub-pixel PX1, a second sub-pixel PX2, and a third sub-pixel PX3. For example, a plurality of red light-emitting devices 150R can be disposed in the first sub-pixel PX1, a plurality of green light-emitting devices 150G can be disposed in the second sub-pixel PX2, and a plurality of blue light-emitting devices 150B can be disposed in the third sub-pixel PX3. The unit pixel PX can further include a fourth sub-pixel in which a light emitting device is not disposed, but is not limited thereto. Meanwhile, the light emitting device 150 can be the semiconductor light emitting device.

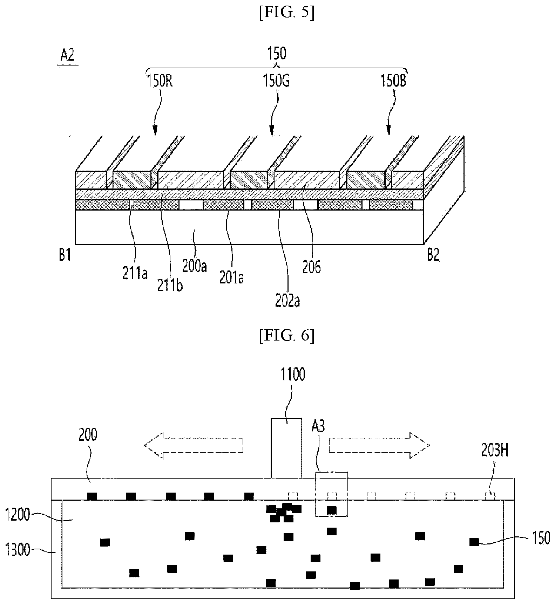

Next, FIG. 5 is a cross-sectional view taken along line B1-B2 of area A2 in FIG. 4.

Referring to FIG. 5, the display device 100 of the embodiment can include a substrate 200a, wirings 201a and 202a spaced apart from each other, a first insulating layer 211a, a second insulating layer 211b, a third insulating layer 206 and a plurality of light emitting devices 150.

The wiring can include a first wiring 201a and a second wiring 202a spaced apart from each other. The first wiring 201a and the second wiring 202a can function as panel wiring for applying power to the light emitting device 150 in the panel, and in the case of self-assembly of the light emitting device 150, Further, the first wiring 201a and the second wiring 202a can function as an assembled electrode for generating a dielectrophoresis force.

The wirings 201a and 202a can be formed of a transparent electrode (ITO) or can include a metal material having excellent electrical conductivity. For example, the wirings 201a and 202a can be formed at least one of titanium (Ti), chromium (Cr), nickel (Ni), aluminum (Al), platinum (Pt), gold (Au), tungsten (W), molybdenum (Mo) or an alloy thereof.

A first insulating layer 211a can be disposed between the first wiring 201a and the second wiring 202a, and a second insulating layer 211b can be disposed on the first wiring 201a and the second wiring 202a. The first insulating layer 211a and the second insulating layer 211b can be an oxide film, a nitride film, or the like, but are not limited thereto.

The light emitting device 150 can include a red-light emitting device 150R, a green-light emitting device 150G, and a blue-light emitting device 150B to form a sub-pixel, respectively, but is not limited thereto. The light emitting device 150 can include a red phosphor and a green phosphor to implement red and green, respectively

The substrate 200a can be formed of glass or polyimide. Further, the substrate 200a can include a flexible material such as polyethylene naphthalate (PEN) or polyethylene terephthalate (PET). In addition, the substrate 200 can be made of a transparent material, but is not limited thereto. The substrate 200a can function as a support substrate in the panel, and can function as a substrate for assembly when self-assembling the light emitting device.

The third insulating layer 206 can include an insulating and flexible material such as polyimide, PEN, or PET, and can be integrally formed with the substrate 200a to form one substrate.

The third insulating layer 206 can be a conductive adhesive layer having adhesiveness and conductivity, and the conductive adhesive layer can be flexible to enable a flexible function of the display device. For example, the third insulating layer 206 can be an anisotropy conductive film (ACF) or a conductive adhesive layer such as an anisotropic conductive medium or a solution containing conductive particles. The conductive adhesive layer can be a layer that is electrically conductive in a direction perpendicular to the thickness but electrically insulating in a direction horizontal to the thickness.

The distance between the first and second wirings 201a and 202a is formed to be smaller than the width of the light emitting device 150 and the width of the assembly hole 203H, so that the assembly position of the light emitting device 150 using an electric field can be more precisely fixed.

A third insulating layer 206 can be formed on the first and second wirings 201a and 202a to protect the first and second wirings 201a and 202a from the fluid 1200, and the third insulating layer 206 is can prevent leakage of current flowing through the two wirings 201a and 202a. The third insulating layer 206 can be formed of a single layer or multiple layers of an inorganic insulator such as silica or alumina or an organic insulator.

In addition, the third insulating layer 206 can include an insulating and flexible material such as polyimide, PEN, PET, etc., and can be formed integrally with the substrate 200 to form a single substrate.

The third insulating layer 206 can have a barrier wall, and an assembly hole 203H can be formed by the barrier wall. For example, the third insulating layer 206 can include an assembly hole 203H through which the light emitting device 150 is inserted (refer to FIG. 6). Accordingly, during self-assembly, the light emitting device 150 can be easily inserted into the assembly hole 203H of the third insulating layer 206. The assembly hole 203H can be referred to as an insertion hole, a fixing hole, or an alignment hole.

The assembly hole 203H can have a shape and a size corresponding to the shape of the light emitting device 150 to be assembled at a corresponding position. Accordingly, it is possible to prevent other light emitting devices from being assembled in the assembly hole 203H or from assembling a plurality of light emitting devices.

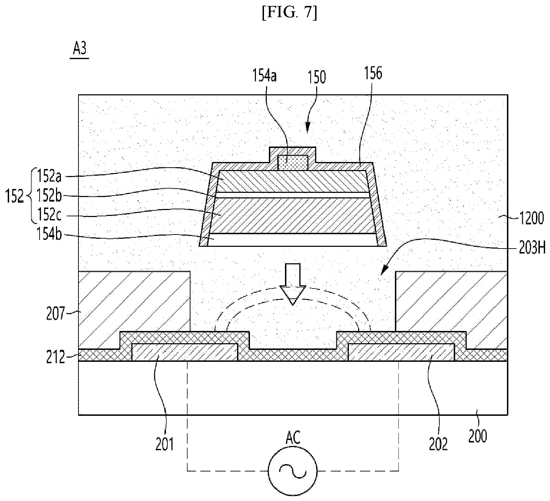

Next, FIG. 6 is a view showing an example in which the light emitting device according to the embodiment is assembled on a substrate by a self-assembly method, and FIG. 7 is a partially enlarged view of area A3 of FIG. 6. And FIG. 7 is a diagram illustrating a state in which area A3 is rotated 180 degrees for convenience of explanation.

An example in which the semiconductor light emitting device according to the embodiment can be assembled in a display panel by a self-assembly method using an electromagnetic field will be described with reference to FIGS. 6 and 7.

The assembly substrate 200 to be described later can also function as the panel substrate 200a in the display device after assembly of the light emitting device, but the embodiment is not limited thereto.

Referring to FIG. 6, the semiconductor light emitting device 150 can be put into the chamber 1300 filled with the fluid 1200, and the semiconductor light emitting device 150 by the magnetic field generated from the assembly device 1100 can move to the assembly substrate 200. In this case, the light emitting device 150 adjacent to the assembly hole 203H of the assembly substrate 200 can be assembled in the assembly hole 230 by a dielectrophoretic force by an electric field of the assembly electrodes. The fluid 1200 can be water such as ultrapure water, but is not limited thereto. A chamber can be referred to as a water bath, container, vessel, or the like.

After the semiconductor light emitting device 150 is put into the chamber 1300, the assembly substrate 200 can be disposed on the chamber 1300. According to an embodiment, the assembly substrate 200 can be introduced into the chamber 1300.

Referring to FIG. 7, the semiconductor light emitting device 150 can be implemented as a vertical semiconductor light emitting device as shown, but is not limited thereto, and a horizontal light emitting device can be employed.

The semiconductor light emitting device 150 can include a magnetic layer having a magnetic material. The magnetic layer can include a magnetic metal such as nickel (Ni). Since the semiconductor light emitting device 150 injected into the fluid can include a magnetic layer, it can move to the assembly substrate 200 by the magnetic field generated from the assembly device1100. The magnetic layer can be disposed above or below or on both sides of the light emitting device.

The semiconductor light emitting device 150 can include a passivation layer 156 surrounding the top and side surfaces. The passivation layer 156 can be formed by using an inorganic insulator such as silica or alumina through PECVD, LPCVD, sputtering deposition, or the like. In addition, the passivation layer 156 can be formed through a method of spin coating an organic material such as a photoresist or a polymer material.

The semiconductor light emitting device 150 can include a first conductivity type semiconductor layer 152a, a second conductivity type semiconductor layer 152c, and an active layer 152b disposed between the first conductivity type semiconductor layer 152a and the second conductivity type semiconductor layer 152c. The first conductivity type semiconductor layer 152a can be an n-type semiconductor layer, and the second conductivity type semiconductor layer 152c can be a p-type semiconductor layer, but is not limited thereto.

A first electrode layer 154a can be disposed on the first conductivity type semiconductor layer 152a, and a second electrode layer 154b can be disposed on the second conductivity type semiconductor layer 152c. To this end, a partial region of the first conductivity type semiconductor layer 152a or the second conductivity type semiconductor layer 152c can be exposed to the outside. Accordingly, after the semiconductor light emitting device 150 is assembled on the assembly substrate 200, a portion of the passivation layer 156 can be etched in the manufacturing process of the display device.

The assembly substrate 200 can include a pair of first assembly electrodes 201 and second assembly electrodes 202 corresponding to each of the semiconductor light emitting devices 150 to be assembled. The first assembly electrode 201 and the second assembly electrode 202 can be formed by stacking a single metal, a metal alloy, or a metal oxide in multiple layers. For example, the first assembled electrode 201 and the second assembled electrode 202 can be formed including at least one of Cu, Ag, Ni, Cr, Ti, Al, Rh, Pd, Ir, Ru, Mg, Zn, Pt, Au, or Hf, but is not limited thereto.

In addition, the first assembly electrode 201 and the second assembly electrode 202 can be formed including at least one of indium tin oxide (ITO), indium zinc oxide (IZO), indium zinc tin oxide (IZTO), indium aluminum zinc oxide (IAZO), IGZO (indium gallium zinc oxide), IGTO (indium gallium tin oxide), AZO (aluminum zinc oxide), ATO (antimony tin oxide), GZO (gallium zinc oxide), IZON (IZO Nitride), AGZO (Al-Ga ZnO), IGZO (In-Ga ZnO), ZnO, IrOx, RuOx, NiO, RuOx/ITO, Ni/IrOx/Au, or Ni/IrOx/Au/ITO, and is not limited thereto.

The first assembled electrode 201, the second assembled electrode 202 emits an electric field as an AC voltage is applied, the semiconductor light emitting device 150 inserted into the assembly hole 203H can be fixed by dielectrophoretic force. A distance between the first assembly electrode 201 and the second assembly electrode 202 can be smaller than a width of the semiconductor light emitting device 150 and a width of the assembly hole 203H, the assembly position of the semiconductor light emitting device 150 using the electric field can be more precisely fixed.

An insulating layer 212 is formed on the first assembly electrode 201 and the second assembly electrode 202 to protect the first assembly electrode 201 and the second assembly electrode 202 from the fluid 1200 and leakage of current flowing through the first assembled electrode 201 and the second assembled electrode 202 can be prevented. For example, the insulating layer 212 can be formed of a single layer or multiple layers of an inorganic insulator such as silica or alumina or an organic insulator. The insulating layer 212 can have a minimum thickness to prevent damage to the first assembly electrode 201 and the second assembly electrode 202 when the semiconductor light emitting device 150 is assembled, and it can have a maximum thickness for the semiconductor light emitting device 150 being stably assembled.

The barrier wall 207 can be formed on the insulating layer 212. A portion of the barrier wall 207 can be positioned on the first assembly electrode 201 and the second assembly electrode 202, and the remaining region can be positioned on the assembly substrate 200.

On the other hand, when the assembly substrate 200 is manufactured, a portion of the barrier walls formed on the entire upper portion of the insulating layer 212 is removed, an assembly hole 203H in which each of the semiconductor light emitting devices 150 is combined and assembled to the assembly substrate 200 can be formed.

An assembly hole 203H to which the semiconductor light emitting devices 150 are coupled is formed in the assembly substrate 200, and a surface on which the assembly hole 203H is formed can be in contact with the fluid 1200. The assembly hole 203H can guide an accurate assembly position of the semiconductor light emitting device 150.

Meanwhile, the assembly hole 203H can have a shape and a size corresponding to the shape of the semiconductor light emitting device 150 to be assembled at a corresponding position. Accordingly, it is possible to prevent assembling other semiconductor light emitting devices or assembling a plurality of semiconductor light emitting devices in the assembly hole 203H.

Referring back to FIG. 6, after the assembly substrate 200 is disposed in the chamber, the assembly device 1100for applying a magnetic field can move along the assembly substrate 200. The assembly device 1100 can be a permanent magnet or an electromagnet.

The assembly device 1100can move while in contact with the assembly substrate 200 in order to maximize the area applied by the magnetic field into the fluid 1200. According to an embodiment, the assembly device 1100 can include a plurality of magnetic materials or a magnetic material having a size corresponding to that of the assembly substrate 200. In this case, the moving distance of the assembly device 1100can be limited within a predetermined range.

The semiconductor light emitting device 150 in the chamber 1300 can move toward the assembly device 1100and the assembly substrate 200 by the magnetic field generated by the assembly device1100.

Referring to FIG. 7, the semiconductor light emitting device 150 is moving toward the assembly device 1100, and can be fixed into the assembly hole 203H by a dielectrophoretic force (DEP force) formed by the electric field of the assembly electrode of the assembly substrate.

In detail, the first and second assembly wirings 201 and 202 can form an electric field by an AC power source, and a dielectrophoretic force can be formed between the assembly wirings 201 and 202 by this electric field. The semiconductor light emitting device 150 can be fixed to the assembly hole 203H on the assembly substrate 200 by this dielectrophoretic force.

At this time, a predetermined solder layer is formed between the light emitting device 150 and the assembly electrode assembled on the assembly hole 203H of the assembly substrate 200 to can improve the bonding force of the light emitting device 150.

In addition, a molding layer can be formed in the assembly hole 203H of the assembly substrate 200 after assembly. The molding layer can be a transparent resin or a resin including a reflective material and a scattering material.

By the self-assembly method using the electromagnetic field described above, the time required for each of the semiconductor light emitting devices to be assembled on the substrate can be rapidly reduced, so that a large-area high-pixel display can be implemented more quickly and economically.

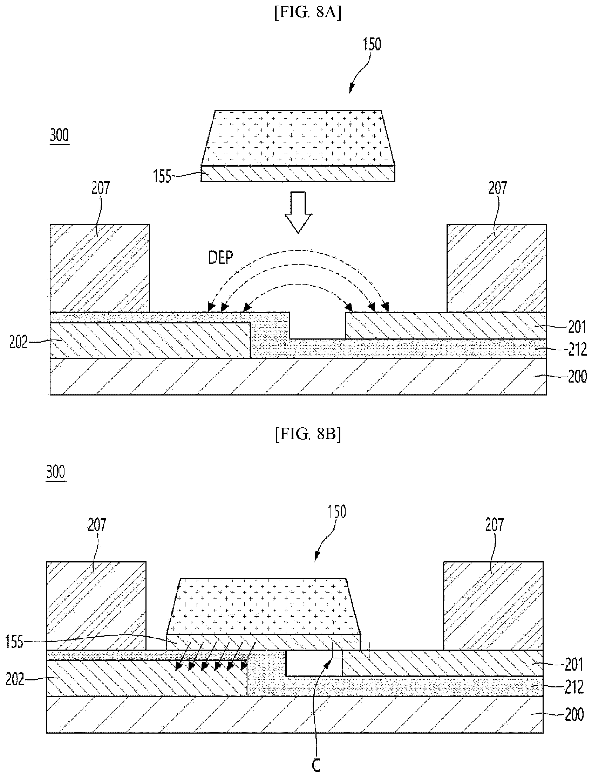

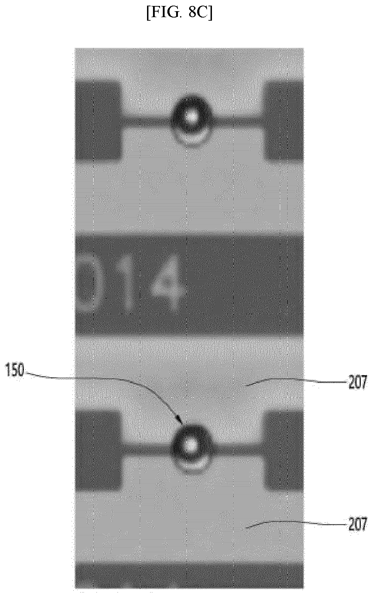

Next, FIGS. 8A to 8B are diagrams illustrating self-assembly in the display device 300 according to the internal technology, and FIG. 8C is a picture of self-assembly in the display device according to the internal technology.

In the display device 300 according to the internal technology, either the first assembly electrode 201 or the second assembly electrode 202 is brought into contact with the bonding metal 155 of the semiconductor light emitting device 150 through a bonding process.

However, in order to solve the problem that the bonding area is also reduced as the semiconductor light emitting device 150 is miniaturized, as shown in FIGS. 8A to 8B, a method of omitting the existing Vdd line and completely opening its role to one side of the electrode wiring is used.

However, when this method is used, the semiconductor light emitting device 150 drawn to the first assembly electrode 201 by DEP in the fluid comes into contact with the first assembly electrode 201 and becomes conductive. Accordingly, the electric field force is concentrated on the second assembled electrode 202 that is not opened by the insulating layer 212, and as a result, there is a problem in that the assembly is biased in one direction.

Referring to FIGS. 8B and 8C, the contact area C between the bonding metal 155 of the semiconductor light emitting device 150 and the first assembly electrode 201 functioning as a panel electrode is very small, so poor contact can occur.

Therefore, according to the undisclosed internal technology, even though DEP Force is required for self-assembly, due to the difficulty of uniform control of the DEP force, there is a problem in that the semiconductor light emitting device tilts to a different place in the assembly hole during assembly using self-assembly.

In addition, due to this tilt phenomenon of the semiconductor light emitting device, electrical contact characteristics are lowered in the subsequent electrical contact process, resulting in a defective lighting rate and a lower yield.

Therefore, according to the unpublished internal technology, even though DEP Force is required for self-assembly, but when using the DEP Force, the semiconductor light emitting device faces a technical contradiction in which electrical contact characteristics are reduced due to the tilt phenomenon.

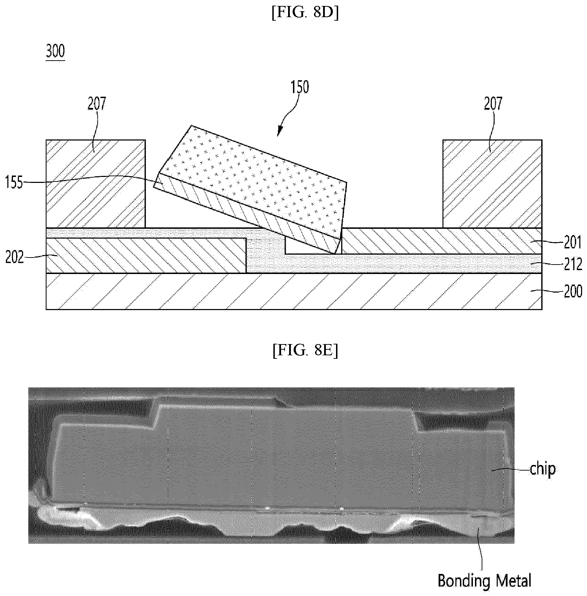

Next, FIG. 8D is a view showing a tilt phenomenon that can occur during self-assembly according to the internal technology.

According to internal technology, an insulating layer 212 is disposed on the first and second assembly electrodes 201 and 202 on the assembly substrate 200, self-assembly by the dielectrophoretic force of the semiconductor light emitting device 150 was performed in the assembly hole H set by the assembly and assembly barrier wall 207. However, according to internal technology, the electric field force is concentrated to the second assembly electrode 202, and as a result, there is a problem in that the assembly is biased in one direction, and thus the problem of self-assembly is not properly performed and the problem of tilt in the assembly hole H has been studied.

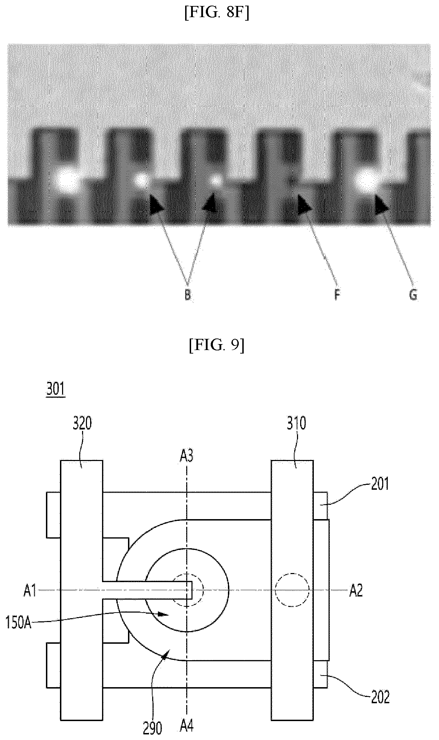

Further, FIG. 8E is a FIB (focused ion beam) photograph of a light emitting device (chip) and bonding metal in a display panel according to an internal technology, and FIG. 8F is lighting data in a display panel in an internal technology.

As shown in FIG. 8E, in the semiconductor light emitting device according to the internal technology, the surface morphology of the back bonding metal is not good, and the contact characteristic between the back bonding metal of the light emitting device and the panel wiring is not good, so lighting failure occurs.

In addition, according to the internal technology, the back bonding metal is in direct contact with the assembly electrode, but electrical contact failure occurs due to the surface non-uniformity of the bonding metal.

For example, FIG. 8F is lighting data in a display panel according to an internal technology.

According to internal technology, in the self-assembly method, there are cases that poor lighting (B: Bad) or non-lighting (F: Fail) occurs due to non-uniformity of DEP force or defective surface properties of the back bonding metal, good lighting (G: Good) cannot be achieved, and lighting rate is studied at the level of 93.94%.

In the internal technology, for the electrode layer of the light emitting device, a material such as Ti, Cu, Pt, Ag, Au can be used. When a bonding metal made of a material such as Sn or In is formed on the electrode layer made of such a material, the surface becomes uneven due to aggregation or the like.

On the other hand, in the internal technology, the deposition rate was increased to improve the surface properties of the bonding metal, but even if the agglomeration phenomenon was partially alleviated, another problem was found that the grain size decreased as the deposition rate increased and the contact force decreased, the problem of improving the surface properties of the bonding metal was not easy.

Hereinafter, a display device including a semiconductor light emitting device according to an embodiment will be described with reference to FIG. 9 and below.

As described above, in the first internal technique (refer to FIG. 7), and in the horizontal assembly electrode structure in which the first assembly electrode and the second assembly electrode are horizontally disposed at the same height, an insulating film is formed on the upper of electrode. In the case of the first internal technology, when the semiconductor light emitting device is a vertical LED, it is difficult to electrically connect the lower electrode and the assembly electrode of the LED without a separate process. But, as the size of the LED chip becomes smaller, the gap between the horizontal assembly electrode structures is getting smaller, it is difficult to form the signal applying electrode.

On the other hand, referring to FIG. 8A, in the vertical asymmetric electrode structure according to the second internal technology, the LED light emitting signal can be applied due to the bonding of the first assembly electrode 201 on the insulating film and the bonding metal 155 of the semiconductor light emitting device. On the other hand, since the assembly electrode structure is asymmetrical, the electric field distribution is also asymmetrically formed, and can be leaned to one side when assembling the semiconductor light emitting device. Further, since the bonding area between the first assembly electrode 201 and the bonding metal 155 on the insulating layer is small, as the size of the light emitting chip becomes smaller, it is difficult to apply a signal (refer FIGS. 8B to 8F ).

One of the technical problems of the embodiment is to solve the problem of low self-assembly rate due to non-uniformity of DEP force in the self-assembly method using dielectrophoresis (DEP).

In addition, one of the technical problems of the embodiment is to solve the problem that the lighting rate is lowered due to the reduction of electrical contact characteristics between the electrodes of the self-assembled light emitting device and a predetermined panel electrode.

A display device 301 including a semiconductor light emitting device according to a first embodiment will be described with reference to FIGS. 9 to 13H (hereinafter, 'first embodiment' will be abbreviated as 'embodiment').

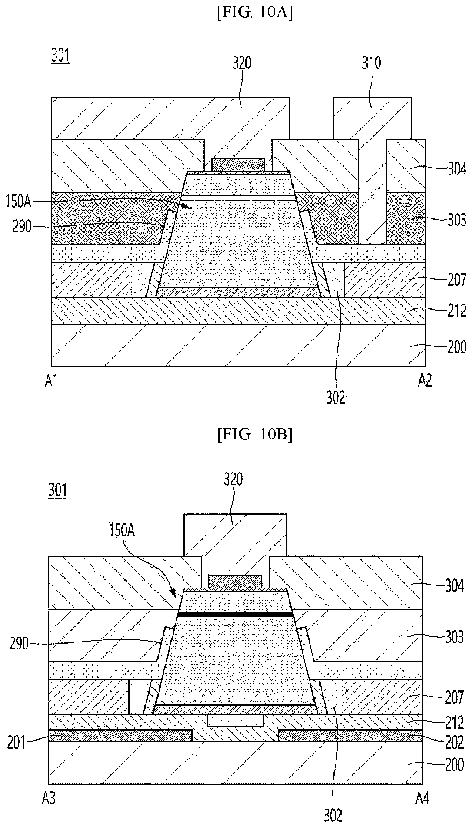

FIG. 9 is a plan view of a display device 301 having a semiconductor light emitting device according to an embodiment. FIG. 10A is a cross-sectional view taken along line A1-A2 of a display device 301 having a semiconductor light emitting device according to the embodiment shown in FIG. 9 and FIG. 10B is a cross-sectional view taken along line A3-A4 of the display device 301 including the semiconductor light emitting device according to the example embodiment shown in FIG. 9.

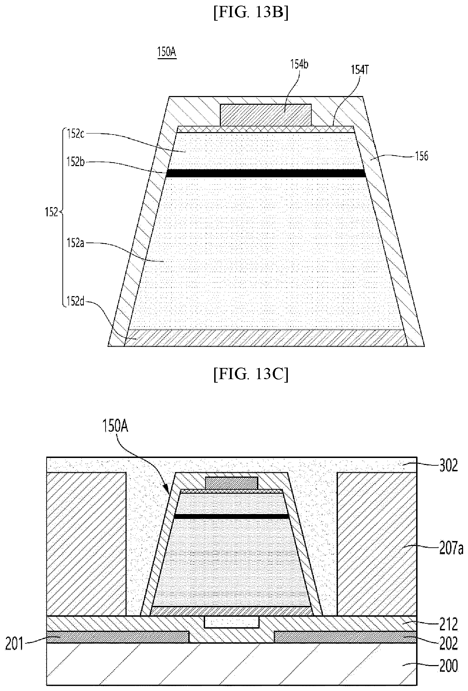

Referring to FIGS. 9 and 10A with a focus on FIG. 10B, the display device 301 having a semiconductor light emitting device according to an embodiment includes a substrate 200, a first assembly electrode 201 and a second assembly electrode 202 disposed on the substrate 200 to be spaced apart from each other, a first insulating layer 212 disposed on the first assembly electrode 201 and the second assembly electrode 202, an assembly barrier wall 207 including a predetermined assembly hole 207H and disposed on the first insulating layer 212, a semiconductor light emitting device 150 (refer to FIG. 13B ) disposed in the assembly hole 207H including a first conductivity type semiconductor layer 152a, a second conductivity type semiconductor layer 152c, an active layer 152b, a side electrode 290 electrically connected to a first side surface of the semiconductor light emitting device and a second panel electrode 320 electrically connected to the second conductivity type semiconductor layer 152c.

The side electrode 290 can be electrically connected to the first conductivity type semiconductor layer 152a of the semiconductor light emitting device 150.

The embodiment includes a second insulating layer 302 disposed in the assembly hole 207H. The second insulating layer 302 can fix a side surface of the semiconductor light emitting device 150.

The embodiment includes a third insulating layer 303 disposed on the second side surface of the semiconductor light emitting device 150 and the side electrode 290. The third insulating layer 303 can be disposed between the side electrode 290 and the active layer 152b of the semiconductor light emitting device 150 to prevent an electrical short circuit and improve reliability.

The embodiment includes a fourth insulating layer 304 disposed on the third side surface of the semiconductor light emitting device 150 and the third insulating layer 303. The fourth insulating layer 304 can be disposed on the second conductivity type semiconductor layer 152c and the third insulating layer 303 to improve electrical reliability.

The embodiment can include the first panel electrode 310 electrically connected to the side electrode 290 and a second panel electrode 320 electrically connected to the second conductivity type semiconductor layer 152c of the semiconductor light emitting device 150.

According to the embodiment, there is a technical effect that the lighting rate can be significantly increased due to the improvement of the electrical contact characteristics by increasing the electrical contact area between the semiconductor light emitting device and the panel electrode. For example, according to an embodiment, as the side electrode 290 can be electrically widely connected to the first conductivity type semiconductor layer 152a of the semiconductor light emitting device 150, by increasing the electrical contact area, the electrical contact characteristics can be improved, and there is a technical effect of remarkably increasing the lighting rate.

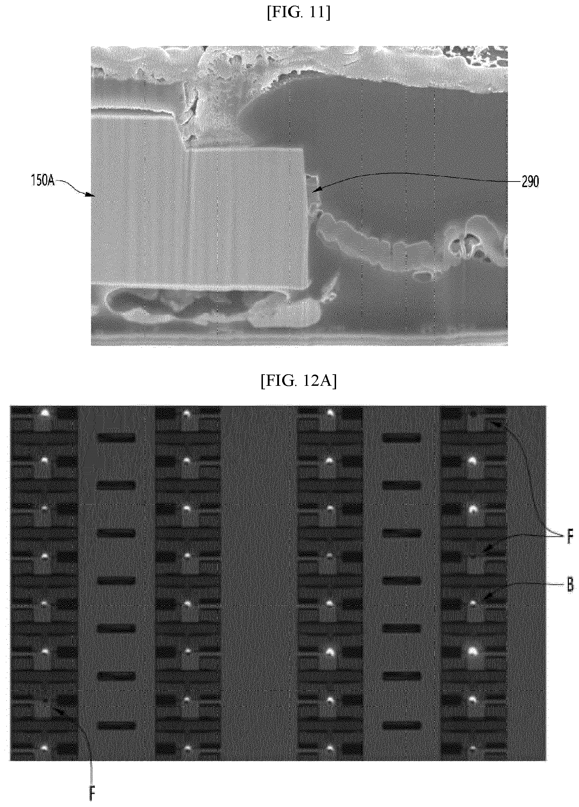

Next, FIG. 11 is a cross-sectional photograph of a display device 301 including a semiconductor light emitting device according to an embodiment.

The display device 301 including the semiconductor light emitting device according to the embodiment can include a side electrode 290 electrically connected to the semiconductor light emitting device 150. The side electrode 290 can be in electrical contact with the first conductivity type semiconductor layer 152a of the semiconductor light emitting device 150.

FIG. 12A is a photograph showing the lighting uniformity of a display device including a semiconductor light emitting device in a comparative example.

A comparative example is an in-bonding method lighting method according to an internal technology. For example, among internal technologies, there is a case in which an electrode connection lighting process using a bonding metal is performed through the lower part of the light emitting device chip as shown in FIG. 8E.

However, there is a case where the uniformity of lighting is low as in the lighting state for each pixel in FIG. 12A.

Especially, according to internal technology, in the self-assembly method, there are cases that poor lighting (B: Bad) or non-lighting (F: Fail) occurs due to skewing or non-uniformity of DEP force or defective surface properties of the back bonding metal, so good lighting (G: Good) may not be achieved, and lighting rate is not high.

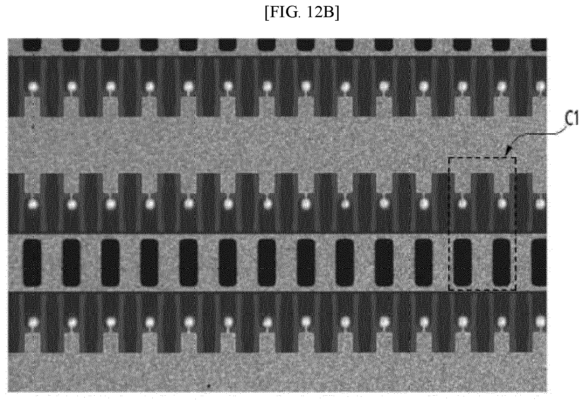

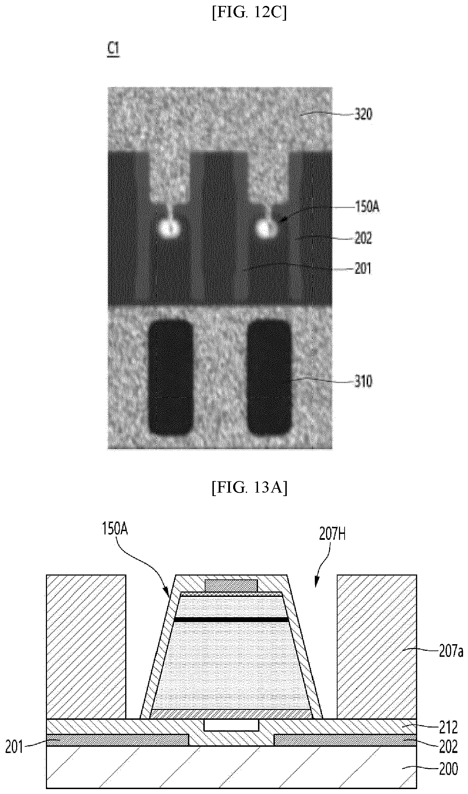

Next, FIG. 12B is a photograph regarding the lighting uniformity of the display device 301 including the semiconductor light emitting device according to the embodiment, and FIG. 12C is an enlarged photograph of the first region C1 in FIG. 12B.

According to the embodiment, by employing a side electrode electrically connected to the side of the semiconductor light emitting device, there is a technical effect that the electrical contact area and contact characteristics can be improved, thereby significantly improving the lighting rate and increasing the uniformity of lighting.

For example, according to the embodiment, the semiconductor light emitting device 150A assembled between the first assembly electrode 201 and the second assembly electrode 202 is disposed, and the semiconductor light emitting device 150A can be electrically connected to the first panel electrode 310 and the second panel electrode 320.

At this time, the display device 301 having a semiconductor light emitting device according to the embodiment can include a side electrode 290 electrically connected to the semiconductor light emitting device 150, the side electrode 290 can be in electrical contact with the first conductivity type semiconductor layer 152a of the semiconductor light emitting device 150.

According to the embodiment, as the side electrode 290 is electrically widely connected to the first conductivity type semiconductor layer 152a of the semiconductor light emitting device 150, by increasing the electrical contact area, the electrical contact characteristics can be improved, and there is a technical effect of remarkably increasing the lighting rate.

Next, FIGS. 13A to 13H are cross-sectional views illustrating a manufacturing process of the display device 301 including the semiconductor light emitting device according to the first embodiment.

Referring to FIG. 13A, a display device 301 having a semiconductor light emitting device according to an embodiment includes a first assembly electrode 201 and a second assembly electrode 202 spaced apart from each other on an assembly substrate 200 a first insulating layer 212 disposed between the first assembly electrode 201 and the second assembly electrode 202, a pre-assembly barrier wall 207a including a predetermined assembly hole 207H and disposed on the first insulating layer 212, and a semiconductor light emitting device 150 disposed in the assembly hole 207H. The semiconductor light emitting device 150 can include a first conductivity type semiconductor layer 152a, a second conductivity type semiconductor layer 152c and an active layer 152b therebetween.

The semiconductor light emitting device 150 can be assembled by DEP force using the first assembly electrode 201 and the second assembly electrode 202.

FIG. 13B is a cross-sectional view of the semiconductor light emitting device 150 according to the embodiment.

The semiconductor light emitting device 150 according to the embodiment shown in FIG. 13B can adopt the technical characteristics of the semiconductor light emitting device 150 shown in FIG. 7.

The semiconductor light emitting device 150 according to the embodiment shown in FIG. 13B can include an undoped semiconductor layer 152d under the light emitting structure 152. Through this, even when the semiconductor light emitting device 150 is turned over and assembled, there is a technical effect that an electrical short is not generated.

Further, the semiconductor light emitting device 150 according to the embodiment may not include a bonding metal under the chip.

The semiconductor light-emitting device 150 according to the embodiment can include a light-transmitting electrode 154T on the light-emitting structure 152.

Next, referring to FIG. 13C, a second insulating layer 302 is formed inside the assembly hole 207H and on the pre-assembly barrier wall 207a.

The second insulating layer 302 can be PAC (photo active compound), and can be formed of photoacryl, but is not limited thereto. In addition, the second insulating layer 302 can be formed of a compound that imparts photosensitivity to a binder resin such as an acrylic photosensitive resin, a no-block resin, polyimide, or a siloxane, but is not limited thereto.

The second insulating layer 302 can serve to stably fix the semiconductor light emitting device 150.

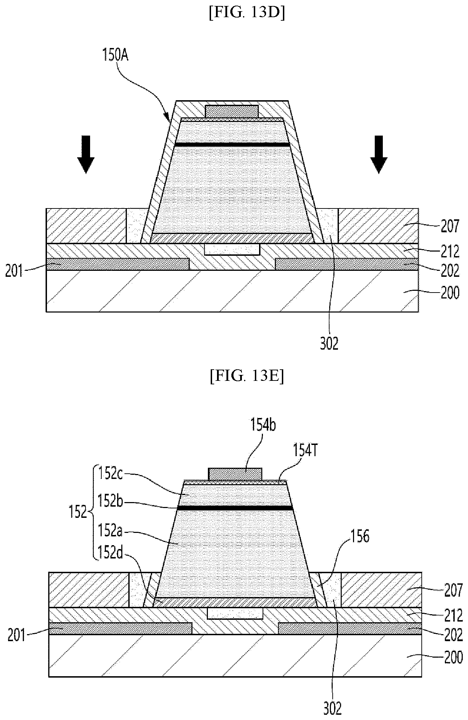

Next, referring to FIG. 13D, a first side surface of the semiconductor light emitting device 150 can be exposed by removing a portion of the upper side of the second insulating layer 302 and the pre-assembly barrier wall 207a.

For example, a portion of the second insulating layer 302 and the pre-assembly barrier wall 207a can be removed by dry etching or the like so as to be exposed to the position of the first conductivity type semiconductor layer 152a of the semiconductor light emitting device 150.

Next, referring to FIG. 13E, the light emitting structure 152 can be exposed by removing the passivation layer 156 on the upper side and part of the first side surface of the semiconductor light emitting device 150.

For example, a portion of the passivation layer 156 can be removed through wet etching to expose the light emitting structure 152 of the semiconductor light emitting device.

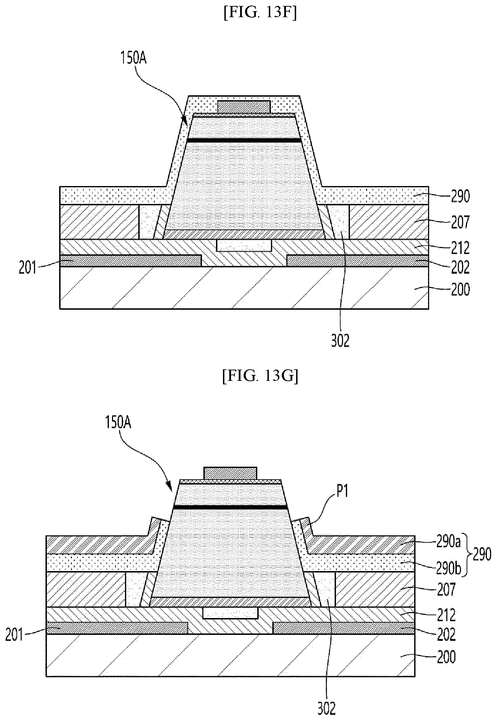

Next, referring to FIG. 13F, side electrode 290 can be formed on the exposed semiconductor light emitting device 150 and the assembly barrier wall 207.

The side electrode 290 can be a metal layer or a conductive photosensitive material. For example, the side electrode 290 can be Mo/Al/Mo or AuGe, but is not limited thereto.

Further, the side electrode 290 can be a conductive photosensitive material. For example, the side electrode 290 can include a conductive liquid photosensitive material. For example, the side electrode 290 can be formed by forming a conductive liquid photosensitive material and then performing exposure and development processes to form the side electrode. The side electrode 290 can be a mixture of a conductive polymer and a photosensitive polymer, but is not limited thereto.

Next, referring to FIG. 13G, a first etch pattern P1 can be formed on the side electrode material, and the side electrode 290 can be patterned using this as a mask.

Through this, the side electrode 290 can include connected to the first side electrode 290a in contact with the semiconductor light emitting device 150 and a second side electrode 290b extending from the first side electrode 290a and electrically connected to a predetermined first panel electrode 310.

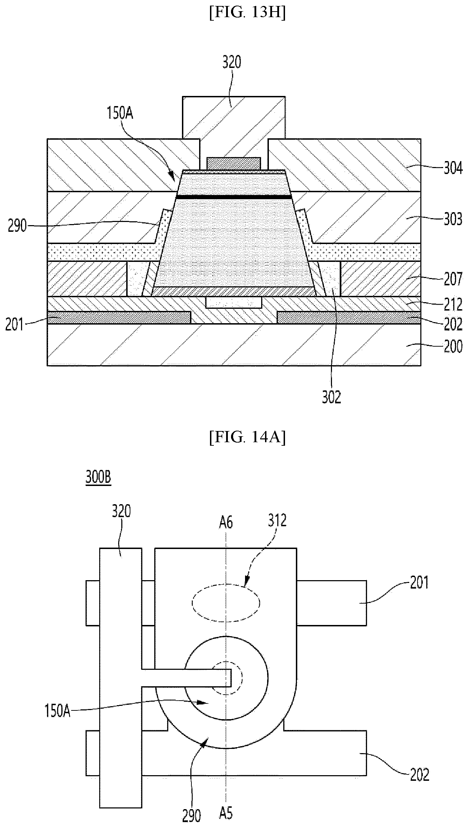

Next, referring to FIG. 13H, the first etching pattern P1 can be removed, and a third insulating layer 303 disposed on the second side surface of the semiconductor light emitting device 150 and the side electrode 290 is formed. The third insulating layer 303 can be disposed between the side electrode 290 and the active layer 152b of the semiconductor light emitting device 150 to prevent an electrical short circuit and improve reliability.

Thereafter, a fourth insulating layer 304 disposed on the third side surface of the semiconductor light emitting device 150 and the third insulating layer 303 is formed. The fourth insulating layer 304 can be disposed on the second conductivity type semiconductor layer 152c and the third insulating layer 303 to improve electrical reliability.

The third insulating layer 303 and the fourth insulating layer 304 can be the material of the second insulating layer 302.

Then, referring to FIGS. 9, 10A and 10B, a first panel electrode 310 electrically connected to the side electrode 290 and a second panel electrode 320 electrically connected to the second conductivity type semiconductor layer 152c of the semiconductor light emitting device 150 can be formed.

According to the semiconductor light emitting device and the display device including the same according to the embodiment, there is a technical effect that can solve the problem of low self-assembly rate due to non-uniformity of DEP force in the self-assembly method using dielectrophoresis (DEP).

In addition, according to the embodiment, there is a technical effect that the lighting rate can be significantly increased by increasing the electrical contact area between the semiconductor light emitting device and the panel electrode to improve the electrical contact characteristics.

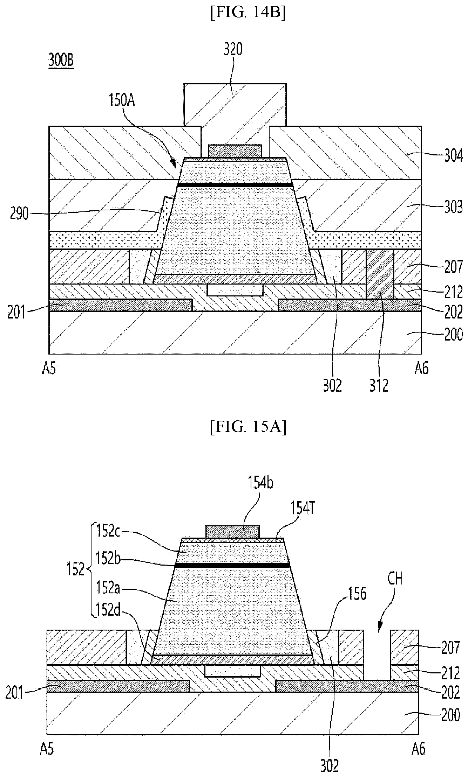

Next, FIG. 14A is a plan view of a display device 300B having a semiconductor light emitting device according to a second embodiment, and FIG. 14B is a cross-sectional view taken along line A5-A6 of the display device 300B including the semiconductor light emitting device according to the second example embodiment shown in FIG. 14A.

The second embodiment can adopt the technical features of the first embodiment, and the following description will focus on the features of the second embodiment.

According to the second embodiment, the first-second panel electrodes 312 connected to the side electrode 290 and the first assembly electrode 201 or the second assembly electrode 202 can be further included.

As the first-second panel electrode 312 is connected to the first assembly electrode 201 or the second assembly electrode 202, the first assembly electrode 201 or the second assembly electrode 202 can have technical effect of being able to function as a panel electrode in a panel.

Next, FIGS. 15A to 15C are cross-sectional views illustrating a manufacturing process of the display device 300B including the semiconductor light emitting device according to the second embodiment.

Referring to FIG. 15A, a display device 300B having a semiconductor light emitting device according to the second embodiment includes a first assembly electrode 201 and a second assembly electrode 202 spaced apart from each other on an assembly substrate 200 a first insulating layer 212 disposed between the first assembly electrode 201 and the second assembly electrode 202, a pre-assembly barrier wall 207a including a predetermined assembly hole 207H and disposed on the first insulating layer 212, and a semiconductor light emitting device 150 disposed in the assembly hole 207H.

The semiconductor light emitting device 150 can be assembled by DEP force using the first assembly electrode 201 and the second assembly electrode 202.

The assembly barrier wall 207 can include a contact hole CH exposing at least one of the first assembly electrode 201 and the second assembly electrode 202.

For example, the assembly barrier wall 207 can include a contact hole CH through which the first insulating layer 212 and a portion of the assembly barrier wall 207 are removed to expose the second assembly electrode 202.

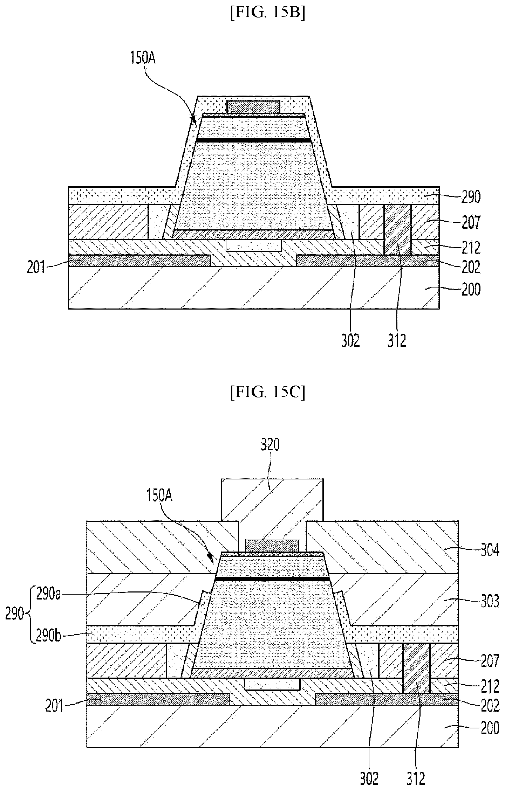

Next, referring to FIG. 15B, a first-second panel electrode 312 can be formed in the contact hole CH.

Thereafter, side electrode 290 can be formed on the exposed semiconductor light emitting device 150 and the assembly barrier wall 207.

The side electrode 290 can be a metal layer or a conductive photosensitive material. For example, the side electrode 290 can be Mo/Al/Mo or AuGe, but is not limited thereto. Further, the side electrode 290 can be formed of a conductive photosensitive material.

Next, referring to FIG. 15C, a predetermined second etch pattern can be formed on the side electrode material, and the side electrode 290 can be patterned using this as a mask.

Through this, the side electrode 290 can include connected to the first side electrode 290a in contact with the semiconductor light emitting device 150 and a second side electrode 290b extending from the first side electrode 290a and electrically connected to a predetermined first panel electrode 310

Next, the second etching pattern can be removed, and a third insulating layer 303 disposed on the second side surface of the semiconductor light emitting device 150 and the side electrode 290 is formed. The third insulating layer 303 can be disposed between the side electrode 290 and the active layer 152b of the semiconductor light emitting device 150 to prevent an electrical short circuit and improve reliability.

Thereafter, a fourth insulating layer 304 disposed on the third side surface of the semiconductor light emitting device 150 and the third insulating layer 303 is formed. The fourth insulating layer 304 can be disposed on the second conductive semiconductor layer 152c and the third insulating layer 303 to improve electrical reliability.

Thereafter, a second panel electrode 320 electrically connected to the second conductivity type semiconductor layer 152c of the semiconductor light emitting device 150 can be formed.

According to the semiconductor light emitting device and the display device including the same according to the embodiment, in the self-assembly method using dielectrophoresis (DEP), there is a technical effect that can solve the problem of low self-assembly rate due to non-uniformity of DEP force.

In addition, according to the embodiment, there is a technical effect that the lighting rate is significantly increased by increasing the electrical contact area between the semiconductor light emitting device and the panel electrode to improve the electrical contact characteristics.

The embodiment can be adopted in the field of display for displaying images or information.

The embodiment can be applied to a display field for displaying an image or information using a semiconductor light emitting device.

The embodiment can be adopted in the field of display for displaying images or information using micro- or nano-level semiconductor light emitting devices.

The above detailed description should not be construed as restrictive in all respects and should be considered as example. The scope of the present invention is defined by the appended claims.

## Claims

1. A display device (301) comprising:
a first assembly electrode (201) and a second assembly electrode (202) spaced apart and disposed on a
substrate (200);
a first insulating layer (212) disposed on the first assembly electrode and the second assembly electrode;
an assembly barrier wall (207) including a predetermined assembly hole (207H) and disposed on the first insulating layer;
a semiconductor light emitting device (150) disposed in the predetermined assembly hole, and including a first conductivity type semiconductor layer (152a), a second conductivity type semiconductor layer (152c), and an active layer (152b);
a side electrode (290) electrically connected to a first side surface of the semiconductor light emitting device;
a second panel electrode (320) electrically connected to the second conductivity-type semiconductor layer;
a second insulating layer (302) disposed in the predetermined assembly hole, wherein the second insulating layer is configured to fix a side surface of the semiconductor light emitting device;
a third insulating layer (303) disposed on a second side surface of the semiconductor light emitting device and the side electrode; and
a fourth insulating layer (304) disposed on a third side surface of the semiconductor light emitting device and the third insulating layer.

2. The display device according to claim 1, wherein the side electrode is electrically connected to the first conductivity type semiconductor layer of the semiconductor light emitting device.

3. The display device according to any one of claims 1 to 2, further comprising a first panel electrode (310) electrically connected to the side electrode.

4. The display device according to any one of claims 1 to 3, wherein the semiconductor light emitting device comprises an undoped semiconductor layer disposed under the first conductivity type semiconductor layer.

5. The display device according to any one of claims 1 to 4, wherein the side electrode comprises:
a first side electrode contacting the semiconductor light emitting device, and
a second side electrode extending from the first side electrode and electrically connected to the first panel electrode.

6. The display device according to any one of claims 1 to 5, further comprising a first-second panel electrode (312), wherein the first-second panel electrode is connected to the side electrode and the first assembly electrode or wherein the first-second panel electrode is connected to the side electrode and the second assembly electrode.

7. The display device according to claim 6, wherein the assembly barrier wall comprises a contact hole (CH) exposing at least one of the first assembly electrode and the second assembly electrode

8. The display device according to claim 7, wherein the assembly barrier wall comprises the contact hole exposing the second assembly electrode, and
wherein the first-second panel electrode is disposed in the contact hole and is connected to the second assembly electrode.

9. The display device according to any one of claims 1 to 8, wherein the side electrode is disposed on an upper surface of the barrier wall.

10. The display device according to any one of claims 1 to 9, wherein the first side surface of the semiconductor light emitting device is inclined.

11. The display device according to any one of claims 1 to 10, wherein the side electrode extends along the side surface of the semiconductor light emitting device towards the upper surface of the semiconductor light emitting device.

12. The display device according to any one of claims 1 to 11, further comprising a second insulation layer encircling the semiconductor light emitting device in the predetermined assembly hole and between the predetermined assembly hole and the assembly barrier wall.

## Patentansprüche

1. Anzeigevorrichtung (301), die aufweist:
eine erste Montageelektrode (201) und eine zweite Montageelektrode (202), die voneinander beabstandet und auf einem Substrat (200) angeordnet sind;
eine erste Isolierschicht (212), die auf der ersten Montageelektrode und der zweiten Montageelektrode angeordnet ist;
eine Montagesperrwand (207), die ein vorbestimmtes Montageloch (207H) enthält und auf der ersten Isolierschicht angeordnet ist;
eine lichtemittierende Halbleitervorrichtung (150), die in dem vorbestimmten Montageloch angeordnet ist, und eine Halbleiterschicht (152a) eines ersten Leitfähigkeitstyps, eine Halbleiterschicht (152c) eines zweiten Leitfähigkeitstyps und eine aktive Schicht (152b) enthält;
eine Seitenelektrode (290), die elektrisch mit einer ersten Seitenfläche der lichtemittierenden Halbleitervorrichtung verbunden ist;
eine zweite Plattenelektrode (320), die elektrisch mit der Halbleiterschicht des zweiten Leitfähigkeitstyps verbunden ist;
eine zweite Isolierschicht (302), die in dem vorbestimmten Montageloch angeordnet ist, wobei die zweite Isolierschicht konfiguriert ist, eine Seitenfläche der lichtemittierenden Halbleitervorrichtung zu fixieren;
eine dritte Isolierschicht (303), die auf einer zweiten Seitenfläche der lichtemittierenden Halbleitervorrichtung und der Seitenelektrode angeordnet ist; und
eine vierte Isolierschicht (304), die auf einer dritten Seitenfläche der lichtemittierenden Halbleitervorrichtung und der dritten Isolierschicht angeordnet ist.

2. Anzeigevorrichtung nach Anspruch 1, wobei die Seitenelektrode elektrisch mit der Halbleiterschicht des ersten Leitfähigkeitstyps der lichtemittierenden Halbleitervorrichtung verbunden ist.

3. Anzeigevorrichtung nach einem der Ansprüche 1 bis 2, die ferner eine erste Plattenelektrode (310) aufweist, die elektrisch mit der Seitenelektrode verbunden ist.

4. Anzeigevorrichtung nach einem der Ansprüche 1 bis 3, wobei die lichtemittierende Halbleitervorrichtung eine undotierte Halbleiterschicht aufweist, die unter der Halbleiterschicht des ersten Leitfähigkeitstyps angeordnet ist.

5. Anzeigevorrichtung nach einem der Ansprüche 1 bis 4, wobei die Seitenelektrode aufweist:
eine erste Seitenelektrode, die die lichtemittierende Halbleitervorrichtung berührt, und
eine zweite Seitenelektrode, die sich von der ersten Seitenelektrode aus erstreckt und elektrisch mit der ersten Plattenelektrode verbunden ist.

6. Anzeigevorrichtung nach einem der Ansprüche 1 bis 5, die ferner eine erste zweite Plattenelektrode (312) aufweist, wobei die erste zweite Plattenelektrode mit der Seitenelektrode und der ersten Montageelektrode verbunden ist oder wobei die erste zweite Plattenelektrode mit der Seitenelektrode und der zweiten Montageelektrode verbunden ist.

7. Anzeigevorrichtung nach Anspruch 6, wobei die Montagesperrwand ein Kontaktloch (CH) aufweist, das mindestens eine der ersten Montageelektrode und der zweiten Montageelektrode freilegt.

8. Anzeigevorrichtung nach Anspruch 7, wobei die Montagesperrwand das Kontaktloch aufweist, das die zweite Baugruppenelektrode freilegt, und
wobei die erste zweite Plattenelektrode in dem Kontaktloch angeordnet ist und mit der zweiten Montageelektrode verbunden ist.

9. Anzeigevorrichtung nach einem der Ansprüche 1 bis 8, wobei die Seitenelektrode auf einer oberen Fläche der Sperrwand angeordnet ist.

10. Anzeigevorrichtung nach einem der Ansprüche 1 bis 9, wobei die erste Seitenfläche der lichtemittierenden Halbleitervorrichtung geneigt ist.

11. Anzeigevorrichtung nach einem der Ansprüche 1 bis 10, wobei sich die Seitenelektrode entlang der Seitenfläche der lichtemittierenden Halbleitervorrichtung zur oberen Fläche der lichtemittierenden Halbleitervorrichtung erstreckt.

12. Anzeigevorrichtung nach einem der Ansprüche 1 bis 11, die ferner eine zweite Isolierschicht aufweist, die die lichtemittierende Halbleitervorrichtung in dem vorbestimmten Montageloch und zwischen dem vorbestimmten Montageloch und der Montagesperrwand umgibt.

## Revendications

1. Dispositif d'affichage (301), comprenant :
une première électrode d'assemblage (201) et une deuxième électrode d'assemblage (202) espacées et disposées sur un substrat (200) ;
une première couche isolante (212) disposée sur la première électrode d'assemblage et la deuxième électrode d'assemblage ;
une paroi de barrière d'assemblage (207) présentant un trou d'assemblage prédéfini (207H) et disposée sur la première couche isolante ;
un dispositif électroluminescent à semi-conducteur (150) disposé dans le trou d'assemblage prédéfini, et présentant une couche semi-conductrice à premier type de conductivité (152a), une couche semi-conductrice à deuxième type de conductivité (152c) et une couche active (152b) ;
une électrode latérale (290) connectée électriquement à une première surface latérale du dispositif électroluminescent à semi-conducteur ;
une deuxième électrode pour écran (320) connectée électriquement à la couche semi-conductrice à deuxième type de conductivité ;
une deuxième couche isolante (302) disposée dans le trou d'assemblage prédéfini, ladite deuxième couche isolante étant prévue pour fixer une surface latérale du dispositif électroluminescent à semi-conducteur ;
une troisième couche isolante (303) disposée sur une deuxième surface latérale du dispositif électroluminescent à semi-conducteur et l'électrode latérale ; et
une quatrième couche isolante (304) disposée sur une troisième surface latérale du dispositif électroluminescent à semi-conducteur et la troisième couche isolante.

2. Dispositif d'affichage selon la revendication 1, où l'électrode latérale est connectée électriquement à la couche semi-conductrice à premier type de conductivité du dispositif électroluminescent à semi-conducteur.

3. Dispositif d'affichage selon la revendication 1 ou la revendication 2, comprenant en outre une première électrode pour écran (310) connectée électriquement à l'électrode latérale.

4. Dispositif d'affichage selon l'une des revendications 1 à 3, où le dispositif électroluminescent à semi-conducteur comprend une couche semi-conductrice non dopée disposée sous la couche semi-conductrice à premier type de conductivité.

5. Dispositif d'affichage selon l'une des revendications 1 à 4, où l'électrode latérale comprend :
une première électrode latérale en contact avec le dispositif électroluminescent à semi-conducteur, et
une deuxième électrode latérale s'étendant à partir de la première électrode latérale et connectée électriquement à la première électrode pour écran.

6. Dispositif d'affichage selon l'une des revendications 1 à 5, comprenant en outre une première-deuxième électrode pour écran (312), où la première-deuxième électrode pour écran est connectée à l'électrode latérale et à la première électrode d'assemblage ou où la première-deuxième électrode pour écran est connectée à l'électrode latérale et à la deuxième électrode d'assemblage.

7. Dispositif d'affichage selon la revendication 6, où la paroi de barrière d'assemblage comprend un trou de contact (CH) exposant la première électrode d'assemblage et/ou la deuxième électrode d'assemblage.

8. Dispositif d'affichage selon la revendication 7, où la paroi de barrière d'assemblage comprend le trou de contact exposant la deuxième électrode d'assemblage, et
où la première-deuxième électrode pour écran est disposée dans le trou de contact et est connectée à la deuxième électrode d'assemblage.

9. Dispositif d'affichage selon l'une des revendications 1 à 8, où l'électrode latérale est disposée sur une surface supérieure de la paroi de barrière.

10. Dispositif d'affichage selon l'une des revendications 1 à 9, où la première surface latérale du dispositif électroluminescent à semi-conducteur est inclinée.

11. Dispositif d' affichage selon l'une des revendications 1 à 10, où l'électrode latérale s'étend le long de la surface latérale du dispositif électroluminescent à semi-conducteur en direction de la surface supérieure du dispositif électroluminescent à semi-conducteur.

12. Dispositif d'affichage selon l'une des revendications 1 à 11, comprenant en outre une deuxième couche d'isolation encerclant le dispositif électroluminescent à semi-conducteur dans le trou d'assemblage prédéfini et entre le trou d'assemblage prédéfini et la paroi de barrière d'assemblage.
